# FASCICULE DE BREVET EUROPEEN

(11) **EP 0 658 931 B1**
(45) Date de publication et mention de la délivrance du brevet: **18.02.1998**
(21) Numéro de dépôt: 94410108.8
(22) Date de dépôt: 30.11.1994
(51) Int. Cl.: H01L 21/768

(54) **Procédé de formation de couches métalliques minces et épaisses**
Herstellungsverfahren von dünnen und dicken metallischen Schichten
Process of making thin and thick metallic layers

(30) Priorité: 03.12.1993 FR 9314744
(43) Date de publication de la demande: 21.06.1995
(73) Titulaire: SGS-THOMSON MICROELECTRONICS S.A., 94250 Gentilly (FR)
(72) Inventeur: Jimenez, Jean, F-38500 Voiron (FR)
(74) Mandataire: de Beaumont, Michel

(56) Documents cités:
- EP-A- 0 195 716
- GB-A- 2 168 846
- IBM TECHNICAL DISCLOSURE BULLETIN., vol.30, no.12, Mai 1988, NEW YORK US pages 142 - 143 'METHOD FOR OBTAINING LOW RESISTANCE AND LOW CAPACITANCE METALIZATION USING SINGLE METAL DEPOSITION'
- PATENT ABSTRACTS OF JAPAN vol. 11, no. 212 (E-522) 9 Juillet 1987 & JP-A-62 033 425 (AGENCY OF IND SCIENCE & TECHNOLOGY) 13 Février 1987

## Description

La présente invention concerne la fabrication des composants semiconducteurs.

Elle concerne plus particulièrement la fabrication de composants dits composants de puissance intelligents ou "Smart Power" qui incluent sur une même puce de silicium des éléments de puissance, souvent réalisés sous forme de transistors MOS verticaux, et une partie logique de commande.

Quand on vise à réaliser de tels composants, on doit utiliser conjointement des technologies de puissance et des technologies de circuits logiques. Ceci implique en particulier des différences sensibles de dimension des connexions, réalisées sous forme de métallisations. En effet, dans la partie logique du composant, ces métallisations doivent être très denses, ce qui entraîne pour des raisons technologiques qu'elles sont relativement minces, une règle couramment admise étant que l'épaisseur d'une métallisation doit être inférieure à la moitié de sa largeur. Ceci ne présente pas d'inconvénient pour les métallisations des circuits logiques qui véhiculent des courants faibles correspondant à des signaux logiques. Par contre, dans la partie de puissance du composant, des courants importants sont véhiculés par les métallisations qui doivent en conséquence être plus larges et plus épaisses.

Diverses techniques ont été proposées dans l'art antérieur, par exemple GB-A-2 168 846, EP-A-0 195 716, et IBM T.D.B., Vol.30(12), p. 142-143, pour permettre la réalisation en un minimum d'étapes des métallisations "minces" et "épaisses". On notera que, bien que l'on parle ici de métallisations épaisses, on se situe toujours dans le domaine de la technologie des couches minoes, c'est-à-dire que ces métallisations "épaisses" ont des épaisseurs qui sont couramment de l'ordre de 1 à 4 micromètres et plus souvent de 2 à 3 micromètres tandis que les métallisations dites minces ont des épaisseurs inférieures à 1 micromètre.

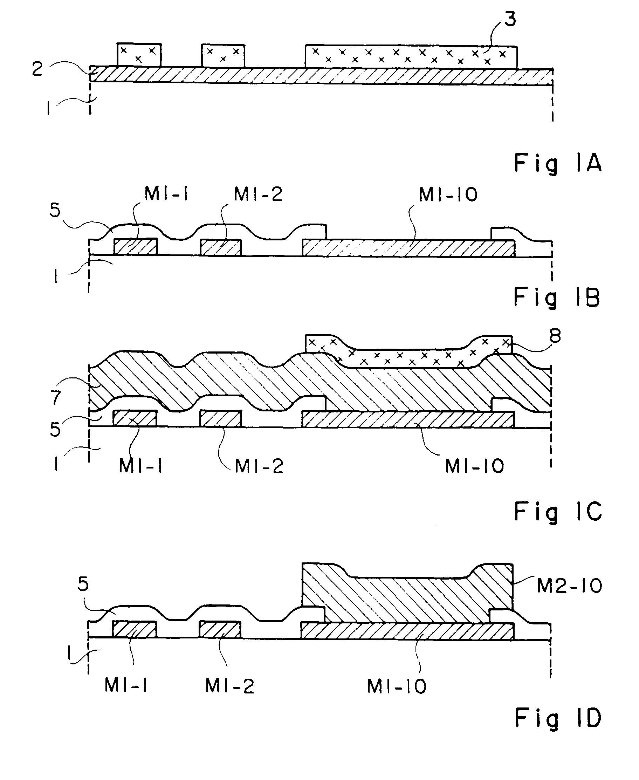

Les figures 1A à 1D illustrent des étapes successives d'un procédé de formation de métallisations selon l'art antérieur. Ces figures représentent des vues en coupe schématiques.

La figure 1A représente un substrat 1, couramment un substrat de silicium, dans lequel ont été formées des structures diffusées souhaitées et qui est éventuellement revêtu par emplacements de couches isolantes, de régions de grille... Sur ce substrat 1, est déposée une couche d'un matériau conducteur métallique 2 dont l'épaisseur est adaptée à la formation de connexions conductrices pour la partie logique du composant. Sur la couche métallique 2 est déposée une couche d'un produit photosensible 3 utilisé en photolithographie qui sera appelé ci-après résine. Cette couche de résine est conformée pour qu'il reste en place des régions correspondant sensiblement aux connexions minces et épaisses à former.

A la suite de cette étape, on obtient, comme le représente la figure 1B, des premières régions métalliques M1-1, M1-2 correspondant aux connexions de la partie logique du composant et des deuxièmes régions métalliques dont une seule M1-10 est représentée. Ensuite, les premières régions métalliques M1-1, M1-2... sont revêtues d'une couche de protection 5, cette couche de protection étant ouverte au-dessus des emplacements des deuxièmes régions métalliques M1-10. Bien entendu, la réalisation de l'ouverture 6 dans la couche 5 implique une étape de dépôt de résine et de photogravure.

A l'étape illustrée en figure 1C, on a déposé une deuxième couche métallique 7 et une couche de résine 8 qui est maintenue en place au-dessus des emplacements des deuxièmes régions.

La figure 1D représente l'état de la structure après gravure de la deuxième couche métallique 7. Comme on le voit, il reste en place des régions de la deuxième couche métallique M2-10 au-dessus de régions correspondantes M1-10 de la première couche métallique.

Ainsi, le procédé illustré nécessite trois opérations de photogravure, la première pour la première couche métallique, la deuxième pour la couche de protection et la troisième pour la deuxième couche métallique. Comme cela est bien connu de l'homme de l'art, une opération de photogravure est relativement délicate à réaliser et prend du temps. Un autre inconvénient de la structure de la figure 1D est que le matériau de la couche de protection 5 doit être choisi parmi un nombre relativement limité de matériaux car, si on souhaite le laisser en place à l'étape finale, cela doit nécessairement être un matériau isolant. Un autre inconvénient du procédé illustré réside dans le fait que la deuxième métallisation ne recouvre pas entièrement la première métallisation puisque, pour tenir compte de défauts éventuels d'alignement de masques, il est nécessaire, comme cela est représenté, que la couche de protection 5 recouvre légèrement la périphérie de la première métallisation au niveau des secondes régions (M1-10). Ceci pose des problèmes supplémentaires si l'on souhaite éliminer la couche de protection 5 car il se produira une sous-gravure latérale à la périphérie des régions métalliques M1-10 et M2-10.

Pour réduire le nombre d'operations de lithogravure, on a aussi proposé dans l'art antérieur d'utiliser des étapes d'enlèvement de couches par attaque de couches sous-jacentes et décollement (lift off) mais ces étapes sont difficiles à maitriser industriellement et sont source de pollution.

La présente invention vise à résoudre ces problèmes.

Ainsi, un premier objet de la présente invention est de prévoir un procédé de fabrication de métallisations minces et épaisses dans lequel le nombre d'opérations de photolithogravure soit réduit sans remplacer les opérations classiques par des procédures complexes.

Un autre objet de la présente invention est de prévoir un tel procédé dans lequel le recouvrement des premier et deuxième niveaux métalliques, pour réaliser les régions épaisses, soit parfaitement conforme.

Pour atteindre ces objets, la présente invention prévoit un procédé de formation sur un substrat de premières régions métalliques d'une première épaisseur et de deuxièmes régions métalliques d'une deuxième épaisseur plus grande que la première épaisseur, comprenant les étapes consistant à déposer une première couche métallique de la première épaisseur sur le substrat ; déposer une couche d'un matériau gravable sélectivement par rapport au métal au-dessus de la première couche métallique ; photograver ledit matériau selon le contour des premières régions ; déposer une deuxième couche métallique sur la première couche métallique et ledit matériau ; former une couche de masquage selon le contour des deuxièmes régions ; graver les première et deuxième couches métalliques ; d'où il résulte qu'il subsiste des premières régions d'une première épaisseur aux emplacements recouverts dudit matériau et des deuxièmes régions d'une deuxième épaisseur correspondant à la superposition des première et deuxième couches métalliques aux emplacements recouverts de ladite couche de masquage.

Selon un mode de réalisation de la présente invention, la gravure du métal est effectuée par gravure ionique réactive.

Selon un mode de réalisation de la présente invention, ledit matériau est du SiO₂ ou du tungstène.

Selon un mode de réalisation de la présente invention, les couches métalliques ont chacune une composition choisie parmi le groupe de matériaux comprenant Al, Al-Ti, Al-Cu, Al-Si, Al-Ti-Si et Al-Cu-Si.

Selon un mode de réalisation de la présente invention, la deuxième couche métallique est plus épaisse que la première.

Selon un mode de réalisation de la présente invention, la première couche métallique a une épaisseur inférieure à un micromètre et la deuxième couche métallique a une épaisseur de l'ordre de 2 à 3 micromètres.

Ces objets, caractéristiques et avantages ainsi que d'autres de la présente invention seront exposés en détail dans la description suivante de modes de réalisation particuliers faite en relation, à titre illustratif, avec les figures jointes parmi lesquelles :
les figures 1A à 1D sont des vues en coupe d'une structure illustrant des étapes successives d'un procédé selon l'art antérieur ; et
les figures 2A à 2D sont des vues en coupe d'une structure illustrant des étapes successives d'un procédé selon un mode de réalisation de la présente invention.

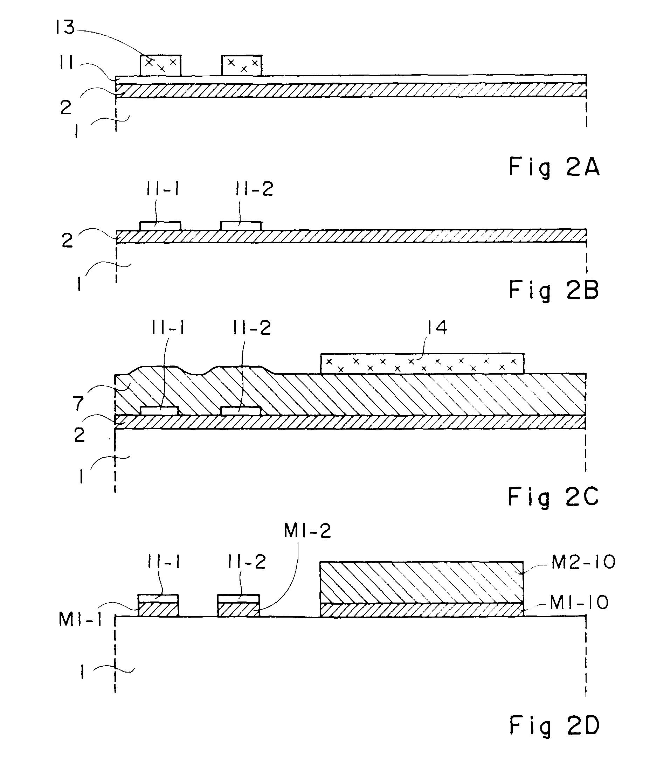

Comme le représente la figure 2A, de même que le procédé de l'art antérieur, le procédé selon la présente invention débute par le dépôt d'une couche métallique mince 2 sur un substrat 1. Au-dessus de ce substrat et de la couche métallique, est déposée une couche de masquage 11 en un matériau qui peut être gravé sélectivement par rapport au métal. On procède ensuite au dépôt d'une couche de résine 13 qui est masquée et gravée pour laisser en place des régions de résine seulement au-dessus de premières régions où l'on veut former des métallisations minces.

Comme le représente la figure 2B, on procède alors à une gravure pour laisser en place les seules régions 11-1 et 11-2 de la couche de masquage 11 situées au-dessus des régions où l'on souhaite former des métallisations minces. Cette gravure est réalisée par un procédé qui n'affecte pas la couche métallique mince 2.

Ensuite, comme le représente la figure 2C, on dépose une deuxième couche métallique 7 compatible avec la première mais non nécessairement identique puis une couche de résine 14 qui est maintenue en place seulement aux emplacements des deuxièmes régions où l'on veut former des métallisations épaisses. On procède alors à une étape de gravure par un procédé qui attaque les première et deuxième couches métalliques mais qui n'affecte pas les portions maintenues en place 11-1 et 11-2 de la couche de masquage 11.

On obtient alors, après enlèvement de la résine, la structure représentée en figure 2D, c'est-à-dire que l'on obtient simultanément une délimitation des régions métalliques minces M1-1 et M1-2 et des régions métalliques épaisses M1-10, M2-10 constituées de la superposition de régions correspondant aux premier et deuxième dépôts métalliques.

Ce procédé présente par rapport au précédent l'avantage essentiel qu'il n'implique que deux opérations de photogravure au lieu de trois.

Un autre avantage de ce procédé est que le recouvrement des deux couches métalliques au niveau des régions épaisses est parfaitement aligné, c'est-à-dire que l'on ne trouve pas à la périphérie de leur région d'interface une portion de couche isolante 5 (voir figure 1D).

La seule exigence relative à la couche de masquage 11 est qu'elle doit être en un matériau sélectivement gravable par rapport au matériau des couches métalliques. De façon générale, les couches métalliques couramment utilisées pour des métallisations de semiconducteur comprennent de l'aluminium et des éventuels mélanges d'aluminium et d'un autre métal, tel que du cuivre ou du titane, et éventuellement aussi un mélange des produits susmentionnés et de silicium. Ainsi, ces métallisations sont par exemple en Al, Al-Ti, Al-Cu, Al-Si, Al-Cu-Si, Al-Ti-Si. De plus, pour obtenir des découpes verticales, on utilise classiquement des procédés de gravure ionique ou des procédés de gravure ionique assistée par plasma (RIE ou PERIE, c.a.d. Plasma Enhanced Ionic Reactive Etching). Dans le cadre de ces procédés, la gravure des matériaux susmentionnés se fait en présence de plasma chloré, par exemple de chlore ou de chlorure de bore. On choisira donc pour le matériau de masquage 11 un matériau gravable en gravure humide ou également en gravure ionique réactive mais dans un plasma fluoré, par exemple dans un plasma de CF4 ou de SF6, sachant que ces plasmas ne permettent pas l'attaque des couches métalliques usuelles susmentionnées.

Le matériau de la couche 11 peut alors être ou bien un matériau isolant tel que l'oxyde de silicium ou bien un métal réfractaire tel que du tungstène. Les métallisations M1-1 et M1-2 se trouvant à l'étape finale recouverte de portions 11-1 et 11-2 de ce matériau, on choisira de préférence un matériau isolant ou un matériau conducteur selon les étapes ultérieures prévues dans le procédé de fabrication du composant.

De façon classique, la couche de matériau de masquage 11 aura une épaisseur de 0,1 à 0,3 µm, la première métallisation une épaisseur inférieure à 1 µm et la deuxième métallisation une épaisseur de l'ordre de 2 à 3 µm.

Les première et deuxième couches de métallisation sont en des matériaux identiques ou distincts, le matériau de la première métallisation étant choisi pour un bon accrochage avec les couches sous-jacentes et pour un bon contact ohmique avec des portions apparentes de silicium ou de silicium polycristallin du substrat avec lesquelles on veut établir un contact.

On notera que les étapes successives prévues par le procédé selon la présente invention, et notamment l'étape de gravure finale, sont bien compatibles avec des procédés usuels de détection de fin d'attaque. Plus généralement, l'homme de métier notera que la présente invention est susceptible de diverses variantes et modifications qui restent dans le domaine de l'invention, ces variantes pouvant notamment porter sur les dimensions des couches et sur les matériaux utilisés, ainsi que sur les modes de gravure.

## Revendications

1. Procédé de formation sur un substrat de premières régions métalliques (M1-1, M1-2) d'une première épaisseur et de deuxièmes régions métalliques (M1-10/M2-10) d'une deuxième épaisseur plus grande que la première épaisseur, comprenant les étapes suivantes :
déposer une première couche métallique (2) de la première épaisseur sur le substrat ;
déposer une couche (11) d'un matériau gravable sélectivement par rapport au métal au-dessus de la première couche métallique ;
photograver ledit matériau selon le contour des premières régions ;
déposer une deuxième couche métallique (7) sur la première couche métallique et ledit matériau ;
former une couche de masquage (14) selon le contour des deuxièmes régions ; et
graver les première et deuxième couches métalliques ; d'où il résulte qu'il subsiste des premières régions d'une première épaisseur aux emplacements recouverts dudit matériau et des deuxièmes régions d'une deuxième épaisseur correspondant à la superposition des première et deuxième couches métalliques aux emplacements recouverts de ladite couche de masquage.

2. Procédé selon la revendication 1, caractérisé en ce que la gravure du métal est effectuée par gravure ionique réactive.

3. Procédé selon la revendication 1, caractérisé en ce que ledit matériau est du SiO₂.

4. Procédé selon la revendication 1, caractérisé en ce que ledit matériau est du tungstène.

5. Procédé selon la revendication 1, caractérisé en ce que les couches métalliques ont chacune une composition choisie parmi le groupe de matériaux comprenant Al, Al-Ti, Al-Cu, Al-Si, Al-Ti-Si et Al-Cu-Si.

6. Procédé selon la revendication 1, caractérisé en ce que la deuxième couche métallique (7) est plus épaisse que la première (2).

7. Procédé selon la revendication 6, caractérisé en ce que la première couche métallique a une épaisseur inférieure à un micromètre.

8. Procédé selon la revendication 6, caractérisé en ce que la deuxième couche métallique a une épaisseur de l'ordre de 2 à 3 micromètres.

## Patentansprüche

1. Verfahren zum Herstellen erster Metallbereiche (M1-1, M1-2) einer ersten Dicke und zweiter Metallbereiche (M1-10, M2-10) einer zweiten Dicke, die größer als die erste Dicke ist, auf einem Substrat, mit folgenden Verfahrensschritten:
Ablagern einer ersten Metallschicht (2) der ersten Dicke auf dem Substrat;
Ablagern einer Schicht (11) aus einem Material, welches im Verhältnis zu dem Metall selektiv ätzbar ist, auf der ersten Metallschicht;
Fotoätzen dieses Materials entlang der Kontur der ersten Bereiche;
Ablagern einer zweiten Metallschicht (7) auf der ersten Metallschicht und dem Material;
Ausbilden einer Maskenschicht (14) entlang der Kontur der zweiten Bereiche; und
Ätzen der ersten und der zweiten Metallschichten;
wodurch erste Bereich einer ersten Dicke bei den Stellen zurückbleiben, welche mit dem Material bedeckt sind, sowie zweite Bereich einer zweiten Dicke, die der Überlagerung der ersten und der zweiten Metallschicht entspricht, bei den Stellen zurückbleiben, die von der Maskenschicht bedeckt sind.

2. Verfahren nach Anspruch 1, dadurch **gekennzeichnet**, daß das Ätzen des Metalls durch reaktives Ionenätzen erfolgt.

3. Verfahren nach Anspruch 1, dadurch **gekennzeichnet**, daß das Material SiO₂ ist.

4. Verfahren nach Anspruch 1, dadurch **gekennzeichnet**, daß das Material Wolfram ist.

5. Verfahren nach Anspruch 1, dadurch **gekennzeichnet**, daß die Metallschichten jeweils eine Zusammensetzung haben, welche aus der folgenden Materialgruppe ausgewählt ist: Al, Al-Ti, Al-Cu, Al-Si, Al-Ti-Si und Al-Cu-Si.

6. Verfahren nach Anspruch 1, dadurch **gekennzeichnet**, daß die zweite Metallschicht (7) dicker ist als die erste (2).

7. Verfahren nach Anspruch 6, dadurch **gekennzeichnet**, daß die erste Metallschicht dünner als 1 µm ist.

8. Verfahren nach Anspruch 6, dadurch **gekennzeichnet**, daß die zweite Metallschicht eine Dicke in der Größenordnung von 2 bis 3 µm hat.

## Claims

1. A method for forming on a substrate first metal regions (M1-1, M1-2) of a first thickness, and second metal regions (M1-10, M2-10) of a second thickness greater than the first thickness, including the following steps:
depositing a first metal layer (2) of a first thickness on the substrate;
depositing a layer (11) of a material selectively etchable with respect to the metal above the first metal layer;
photoetching said material along the outline of the first regions;
depositing a second metal layer (7) above the first metal layer and said material;
forming a masking layer (14) along the outline of the second regions; and
etching said first and second metal layers;
whereby there remain first layers of a first thickness at the places coated with said material and second regions of a second thickness corresponding to the superposition of the first and second metal layers at the places coated with said masking layer.

2. The method of claim 1, characterized in that the metal is etched through reactive ionic etching.

3. The method of claim 1, characterized in that said material is SiO₂.

4. The method of claim 1, characterized in that said material is tungsten.

5. The method of claim 1, characterized in that the composition of each metal layer is selected from among the group of materials including Al, Al-Ti, Al-Cu, Al-Si, Al-Ti-Si and Al-Cu-Si.

6. The method of claim 1, characterized in that the second metal layer (7) is thicker than the first layer (2).

7. The method of claim 6, characterized in that the first metal layer has a thickness smaller than 1 µm.

8. The method of claim 6, characterized in that the second metal layer has a thickness of approximately 2 to 3 µm.
